**Europäisches Patentamt**

**European Patent Office**

**Office européen des brevets**

(19)

(11) Numéro de publication : **0 189 340**
**B1**

(12)

# FASCICULE DE BREVET EUROPÉEN

(45) Date de publication du fascicule du brevet :
17.05.89

(51) Int. Cl.⁴ : **H 02 M 7/06, H 02 H 9/00**

(21) Numéro de dépôt : 86400054.2

(22) Date de dépôt : 10.01.86

(54) Circuit de commutation utilisant une diode rapide, et pourvu de moyens d'amortissement des oscillations à l'ouverture.

(30) Priorité : 15.01.85 FR 8500522

(43) Date de publication de la demande :
30.07.86 Bulletin 86/31

(45) Mention de la délivrance du brevet :
17.05.89 Bulletin 89/20

(84) Etats contractants désignés :
CH DE FR GB IT LI NL

(56) Documents cités :
FR–A– 2 405 576

(73) Titulaire : THOMSON-CSF
173, Boulevard Haussmann
F-75379 Paris Cedex 08 (FR)

(72) Inventeur : Rischmuller, Klaus
THOMSON-CSF SCPI 173, bld Haussmann
F-75379 Paris Cedex 08 (FR)

(74) Mandataire : Rinuy, Santarelli
14, avenue de la Grande Armée
F-75017 Paris (FR)

## Description

La présente invention concerne les circuits de commutation tels que les convertisseurs, les alimentations à découpage, les hacheurs, les onduleurs, etc...

Ces circuits comprennent souvent des diodes de redressement en série avec des charges inductives et il est nécessaire d'utiliser des diodes dites rapides, c'est-à-dire des diodes se bloquant rapidement lors de l'inversion de la tension à leurs bornes.

Mais, compte tenu des inductances et capacités du circuit dans lequel sont placées ces diodes, il apparaît souvent, au moment du blocage, des oscillations de courant et de tension. Ces oscillations créent des perturbations du circuit comme par exemple une remise en conduction anormale de transistors ou des signaux parasites affectant la logique de commande du circuit. Elles créent aussi des parasites sur la tension de sortie des circuits (alimentations, onduleurs etc...) et des perturbations radioélectriques.

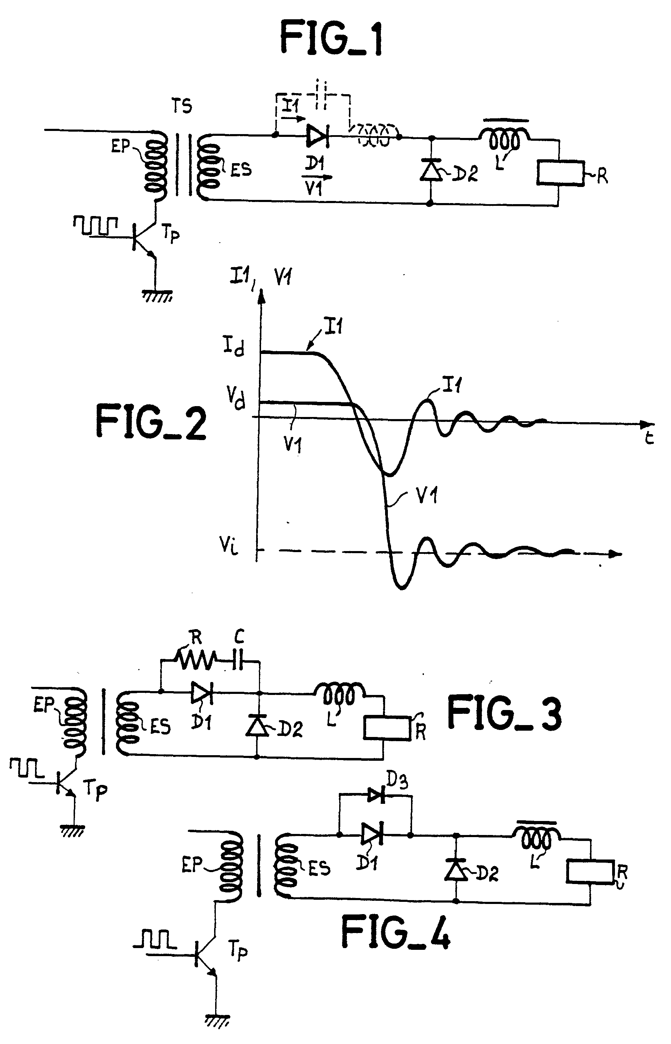

La figure 1 montre à titre d'exemple un circuit de redressement placé aux bornes de l'enroulement secondaire ES du transformateur de sortie TS d'une alimentation à découpage (l'enroulement primaire EP étant en série avec un commutateur $T_p$ actionné à la fréquence de découpage). Ce circuit comprend par exemple une diode rapide de redressement D1 en série entre l'enroulement secondaire ES et la charge inductive L, R et une autre diode D2 en parallèle avec la charge seule.

On a représenté en pointillés sur la figure 1 une inductance parasite (inductance de câblage) et une capacité parasite (de la diode D1).

La figure 2 montre les formes d'onde du courant I1 dans la diode de redressement D1 et la tension V1 à ses bornes au moment de la commutation, c'est-à-dire au moment de la transition de passage d'un courant direct Id important à un courant nul et d'une tension directe faible Vd à une tension inverse négative élevée Vi. Cette transition présente des oscillations importantes qu'il faudrait amortir fortement sans toutefois créer des pertes trop importantes et sans utiliser un nombre de composants important.

Ce que l'on a fait jusqu'à maintenant c'est de brancher en parallèle sur la diode D1 un réseau RC série, comme le représente la figure 3.

Ceci a cependant plusieurs défauts :

— l'inductance de câblage du circuit crée un réseau RLC série qui n'est pas suffisamment amorti, surtout pour des oscillations haute fréquence, étant donné qu'on ne peut pas augmenter la valeur du condensateur C (pour augmenter l'amortissement) sans créer des pertes importantes (car la capacité C est chargée et déchargée à travers la résistance R à chaque alternance),

— une augmentation de la capacité C, outre les pertes importantes créées réduit l'effet de redressement,

— les composants rajoutés, résistance et capacité, sont relativement volumineux, et nécessitent une certaine longueur de conducteurs de connexion, ce qui empêche une réduction de l'inductance de câblage,

— enfin, la résistance et la capacité ne peuvent être intégrées sur une puce semiconductrice avec les diodes D1 et D2.

Pour résoudre ces différents problèmes, la présente invention propose de mettre en parallèle sur la diode rapide de redressement D1 une diode « lente » D3. Cette diode D3 a une surface de jonction nettement plus faible que celle de la diode rapide D1 et une rapidité de commutation vers l'état bloqué également nettement plus faible que celle de la diode D1.

L'attention est attirée sur le brevet FR 2 405 576 qui montre une diode de protection en parallèle sur une autre. Mais il s'agit de protection contre les surtensions et la diode de protection est une diode rapide.

On décrira ci-après plus en détail les caractéristiques de l'invention en référence aux dessins annexés dans lesquels :

— pour mémoire les figures 1 à 3 représentent l'état de la technique,

— la figure 4 représente un schéma d'alimentation selon l'invention,

— les figures 5a à 5c représentent des formes d'onde de courants,

— les figures 6 et 7 représentent deux exemples de montage pratique de diodes.

La figure 4 est identique à la figure 3 à l'exception du fait que l'ensemble de la résistance R et de la capacité C est remplacé par une diode D3, plus lente et de plus faible surface de jonction que la diode D1, en parallèle sur la diode D1.

Lors de la commutation à l'ouverture la diode D1 rapide se bloque la première. La diode D3 recouvre son état bloqué plus lentement, avec un courant de recouvrement IRD3 qui est d'abord une fraction du courant de recouvrement IRD1 de la diode D1. Ce courant de recouvrement négatif diminue progressivement, plus lentement que celui de la diode D1, et amortit les oscillations de ce dernier. En effet, lorsque le courant dans la diode D1 tend à redevenir positif, il est compensé par le courant dans la diode D3 qui au même moment est négatif. L'addition algébrique des deux courants suit une forme d'onde beaucoup plus amortie que celle du courant dans la diode D1 seule. Or c'est cette addition qui constitue le courant.

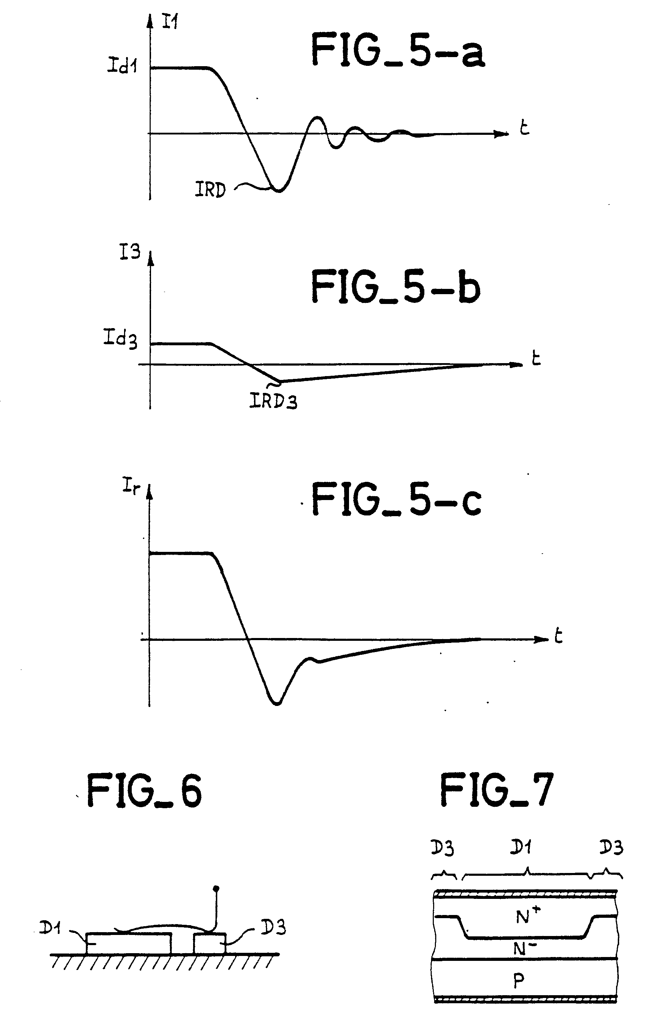

La figure 5a représente la forme d'onde du courant dans la diode D1 supposée seule (courant initial Id1, courant de recouvrement IRD1).

La figure 5b représente la forme d'onde du courant dans la diode D1 supposée seule (courant initial Id3, courant de recouvrement IRD3).

La figure 5c représente le courant global qui résulte de la mise en parallèle des deux diodes et d'amortissement important qui en résulte.

A titre d'exemple on peut utiliser une diode lente de courant nominal dix fois plus faible que le courant nominal de la diode rapide, le temps de recouvrement de la diode lente étant typiquement de quelques microsecondes alors que celui de la diode rapide est de quelques dizaines de nanosecondes (temps entre le premier pic négatif de courant et le premier passage à zéro qui suit ce pic).

Les pertes ne sont pratiquement pas augmentées par rapport aux pertes avec une diode rapide seule.

La figure 6 représente un mode de réalisation simple : les diodes sont constituées par des pastilles semiconductrices distinctes soudées sur un même support de sorte qu'elles peuvent être montées dans un boîtier unique (permettant ainsi une limitation des inductances de câblage).

La diode D1 est dopée à l'or ou au platine pour accélérer la recombinaison des porteurs présents dans les régions semiconductrices juste avant le blocage. la diode D3 n'est pas dopée avec de l'or ou du platine, ou elle ne l'est que faiblement.

La figure 7 propose une autre réalisation : les deux diodes sont réalisées sur un même substrat semiconducteur. La zone centrale constitue la diode D1 rapide, la zone périphérique constitue la diode D3 plus lente. la surface de zone centrale est plus importante que celle de la zone périphérique pour que le courant principal passe dans la diode D1. L'épaisseur de zone N la moins dopée est plus importante à la périphérie que, dans la zone centrale, de sorte que la durée de vie des porteurs est plus longue dans la zone correspondant à la diode D3. Pour réaliser cette diode combinée D1 + D3 il suffit de prévoir que le dopage de la région de contact ohmique (de type $N^+$) de la cathode de la diode est diffusé en deux étapes dont l'une consiste en une diffusion profonde localisée dans la zone centrale avec un masque de diffusion protégeant la zone périphérique, l'autre étape étant une diffusion non localisée de la même impureté ou d'une impureté de même type.

On peut envisager d'autres modes de réalisation de la diode D3 sous forme intégrée ou non, y compris un mode de réalisation dans lequel la diode D3 est constituée par la jonction base collecteur d'un transistor dont l'émetteur est relié directement à une métallisation d'anode de la diode : le recouvrement dans ce transistor monté en diode est plus lent que dans la diode principale.

## Revendications

1. Circuit de protection pour un circuit de commutation utilisant au moins une diode rapide (D1) en plaçant en parallèle sur cette diode (D1) une diode supplémentaire (D3) ayant des caractéristiques différentes, caractérisé en ce que, pour amortir les oscillations susceptibles de se produire au moment du passage de la diode d'un état de conduction direct à un état de blocage les caractéristiques de la diode supplémentaire (D3) sont choisies de telle sorte qu'elle ait une plus faible rapidité de blocage et une plus petite section de passage du courant que la diode rapide.

2. Circuit de protection selon la revendication 1, caractérisé en ce que la diode rapide est une puce semiconductrice dopée avec des centres de recombinaison (or, platine, etc...) et la diode supplémentaire est une diode non dopée avec des centres de recombinaison.

3. Circuit de protection selon la revendication 1, caractérisé en ce que la diode rapide et la diode supplémentaire sont réalisées sur une même puce semiconductrice, l'épaisseur de région de cathode N peu dopée entre une région $N^+$ de contact ohmique de cathode et une région P d'anode étant plus grande dans la région de la diode supplémentaire que dans la région de la diode rapide.

## Claims

1. A protection circuit for a commutation circuit employing at least one fast diode (D1) and comprising a supplementary diode (D3) having different characteristics disposed in parallel with this diode (D1), characterized in that in order to damp the oscillations which may be produced at the instant when the diode changes from a forward conducting state to a blocked state, the characteristics of the supplementary diode (D3) are chosen so that it blocks more slowly and has a smaller cross-section for the passage or current than the fast diode.

2. A protection circuit according to Claim 1, characterized in that the fast diode is a semiconductor chip doped with recombination centres (gold, platinum, etc...) and the supplementary diode is a diode not doped with recombination centres.

3. A protection circuit according to Claim 1, characterized in that the fast diode and the supplementary diode are formed on the same semiconductor chip, the thickness of the lightly doped cathode region N between an ohmic contact region $N^+$ of the cathode and an anode region P being greater in the supplementary diode zone than in the fast diode zone.

## Patentansprüche

1. Schutzschaltung für eine Kommutierungsschaltung mit mindestens einer schnellen Diode (D1), wobei parallel zu der Diode (D1) eine zusätzliche Diode (D3) mit unterschiedlichen Eigenschaften geschaltet ist, dadurch gekennzeichnet, daß zur Dämpfung von Oszillationen, die im Moment des Übergangs der Diode aus dem Gleichstrom leitenden Zustand in einen Sperrzustand entstehen können, die Eigenschaften der zusätzlichen Diode (D3) so gewählt werden, daß sie eine größere Sperrverzögerungszeit und einen kleineren Stromflußquerschnitt als die schnelle Diode aufweist.

2. Schutzschaltung nach Anspruch 1, dadurch gekennzeichnet, daß die schnelle Diode ein Halbleiterchip, dotiert mit Rekombinationszentren (Gold, Platin, usw.) ist, und daß die zusätzliche Diode eine nicht mit Rekombinationszentren dotierte Diode ist.

3. Schutzschaltung nach Anspruch 1, dadurch gekennzeichnet, daß die schnelle Diode und die zusätzliche Diode auf dem gleichen Halbleiterchip verwirklicht sind, wobei die Dicke des wenig dotierten Kathodenbereichs N, der zwischen einem Bereich $N^+$ mit ohm'schen Kathodenkontakt und einem Anodenbereich P liegt, im Bereich der zusätzlichen Diode größer ist als im Bereich ·der schnellen Diode.

# FIG_1

# FIG_2

# FIG_3

# FIG_4

FIG_5-a

FIG_5-b

FIG_5-c

FIG_6

FIG_7

2